(19) Europäisches Patentamt
European Patent Office
Office européen des brevets

(11) **EP 3 839 548 A1**

(12) **EUROPÄISCHE PATENTANMELDUNG**

(43) Veröffentlichungstag:
**23.06.2021 Patentblatt 2021/25**

(51) Int Cl.:
*G01R 33/561* (2006.01)  *G01R 33/48* (2006.01)
*G01R 33/483* (2006.01)

(21) Anmeldenummer: **19217905.9**

(22) Anmeldetag: **19.12.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(71) Anmelder: **Siemens Healthcare GmbH**
**91052 Erlangen (DE)**

(72) Erfinder:
• **Feiweier, Thorsten**
**91099 Poxdorf (DE)**
• **Hilbert, Tom**
**1006 Lausanne (CH)**
• **Kober, Tobias**
**1007 Lausanne (CH)**

(54) **SIMULTANE MEHRSCHICHTMAGNETRESONANZBILDGEBUNG MIT UNREGELMÄSSIGER UND UNVOLLSTÄNDIGER K-RAUM-ABTASTUNG**

(57) Die Erfindung betrifft ein Verfahren zur simultanen Mehrschichtmagnetresonanzmessung, eine entsprechende Magnetresonanzvorrichtung (10) sowie ein entsprechendes Computerprogrammprodukt.

Es wird ein Verfahren zur Magnetresonanzmessung zumindest einer Gruppe simultan angeregter Schichten entlang einer Schichtachse vorgeschlagen. Dabei wird ein abzutastender Frequenzraumbereich in einem Frequenzraum mittels einer Systemsteuereinheit (22) festgelegt. Hierbei wird eine erste Frequenzraumdimension (ky) einer ersten phasenkodierten Achse zugeordnet und eine zweite Frequenzraumdimension (kz) wird, einer zweiten phasenkodierten Achse zugeordnet, wobei die zweite phasenkodierte Achse der Schichtachse entspricht. Ferner wird mittels der Systemsteuereinheit (22) für jede Gruppe der simultan angeregten Schichten ein mehrere Abtastpunkte (P) umfassendes Unterabtastungsschema festgelegt. Dabei wird entlang der ersten Frequenzraumdimension (ky) und/oder zweiten Frequenzraumdimension (kz) eine unregelmäßige, unvollständige Abtastung des Frequenzraumbereichs vorgesehen. Zudem wird eine Magnetresonanzmessung der zumindest eine Gruppe der simultan angeregten Schichten entlang der Schichtachse gemäß dem jeweiligen Unterabtastungsschema zur Akquisition von Magnetresonanzsignalen durchgeführt.

FIG 7

| | P1 | P2 | P3 | P4 | P5 | P6 | P7 | P8 | P9 | P10 | P11 | P12 | P13 | P14 | P15 | P16 | P17 | P18 | P19 | P20 |
|---|---|---|---|---|---|---|---|---|---|---|---|---|---|---|---|---|---|---|---|---|
| $n_y$ | -7 | -6 | -6 | -5 | -4 | -3 | -1 | 0 | 0 | 1 | 1 | 1 | 2 | 3 | 4 | 4 | 5 | 6 | 7 | |
| $n_z$ | -1 | -2 | 1 | -2 | 0 | -2 | 1 | -1 | -1 | 0 | -1 | 0 | 1 | -2 | 0 | 0 | 1 | -1 | 1 | -2 |
| D | 7,1 | 6,3 | 6,1 | 5,4 | 4,0 | 3,6 | 3,2 | 1,4 | 1,0 | 0,0 | 1,4 | 1,0 | 1,4 | 2,8 | 3,0 | 4,0 | 4,1 | 5,1 | 6,1 | 7,3 |

| | P10 | P9 | P12 | P8 | P11 | P13 | P14 | P15 | P7 | P6 | P5 | P16 | P17 | P18 | P4 | P3 | P19 | P2 | P1 | P20 |
|---|---|---|---|---|---|---|---|---|---|---|---|---|---|---|---|---|---|---|---|---|
| D | 0,0 | 1,0 | 1,0 | 1,4 | 1,4 | 1,4 | 2,8 | 3,0 | 3,2 | 3,6 | 4,0 | 4,0 | 4,1 | 5,1 | 5,4 | 6,1 | 6,1 | 6,3 | 7,1 | 7,3 |
| $I_E$ | 0 | 0 | 0 | 0 | 0 | 1 | 1 | 1 | 1 | 1 | 2 | 2 | 2 | 2 | 2 | 3 | 3 | 3 | 3 | 3 |

| | P10 | P13 | P5 | P3 | P9 | P14 | P16 | P3 | P12 | P15 | P17 | P2 | P8 | P7 | P18 | P1 | P11 | P6 | P4 | P20 |
|---|---|---|---|---|---|---|---|---|---|---|---|---|---|---|---|---|---|---|---|---|
| $I_A$ | 0 | 0 | 0 | 0 | 1 | 1 | 1 | 1 | 2 | 2 | 2 | 2 | 2 | 3 | 3 | 3 | 4 | 4 | 4 | 4 |
| $I_E$ | 0 | 1 | 2 | 3 | 0 | 1 | 2 | 3 | 0 | 1 | 2 | 3 | 0 | 1 | 2 | 3 | 0 | 1 | 2 | 3 |

EP 3 839 548 A1

**Beschreibung**

Die Erfindung betrifft ein Verfahren zur simultanen Mehrschichtmagnetresonanzmessung, eine entsprechende Magnetresonanzvorrichtung sowie ein entsprechendes Computerprogrammprodukt.

Magnetresonanztomographie (MRT, engl. magnetic resonance imaging, MRI) ist eine weitverbreitete medizinische Bildgebungsmethode, die sich insbesondere durch einen guten Weichgewebekontrast auszeichnet. Hierbei werden mit Hilfe eines Magnetresonanzvorrichtung hochfrequente (HF) Pulse in ein Untersuchungsobjekt, insbesondere ein Patient, eingestrahlt. Die HF-Pulse regen eine Magnetisierung im Gewebe des Untersuchungsobjekts an, weshalb sie auch Anregungspulse genannt werden. Durch Präzession der Magnetisierung werden Magnetresonanzsignale ausgelöst, die als Messdaten von der Magnetresonanzvorrichtung empfangen und zur Rekonstruktion von Magnetresonanzabbildungen verwendet werden.

Jedoch kann bei der Magnetresonanztomographie die Aufnahme der Messdaten und somit die Untersuchungszeit im Vergleich zu anderen Bildgebungsmethoden wie der Computertomographie (CT) deutlich länger dauern. Das bringt mehrere Nachteile mit sich, wie zum Beispiel einen reduzierten Patientenkomfort, eine höhere Wahrscheinlichkeit von Bewegungsartefakten und erhöhte Kosten aufgrund eines geringeren Patientendurchsatzes.

Die Beschleunigung von Magnetresonanzmessungen steht daher seit vielen Jahren im Fokus der Forschung, und verschiedene Methoden zur Verbesserung dieses Problems wurden vorgeschlagen.

Mit der parallelen Bildgebung wird die Magnetresonanzmessungen beschleunigt, indem bei der Messung das Signal unterabgetastet wird. Das bedeutet, dass im Frequenzraum nicht genügend Datenpunkte aufgenommen werden, um das Nyquist-Shannon-Kriterium einzuhalten, d.h. es werden theoretisch nicht genügend Daten aufgenommen, um das Signal bzw. die Magnetresonanzabbildung vollständig zu rekonstruieren. Die daraus entstehenden Unterabtastungseffekte führen oftmals zu Aliasingartefakten im Bildraum. Durch Nutzung von redundanten Informationen in den Daten der - heutzutage üblichen - Mehrkanal-Empfangsspulen kann man diese Aliasingartefakte reduzieren, da die Spulen das Magnetresonanzsignal zeitgleich mit mehreren Spulenelementen aufnehmen.

In einer zweidimensionalen Aufnahme führt man bei der parallelen Bildgebung eine regelmäßige Unterabtastung entlang der Phasenkodierungsachse des Frequenzraums aus. Die fehlenden Datenpunkte werden dann durch Ausnutzung der räumlichen Sensitivitätsprofile der Spulenelementen im Frequenzraum, z.B. bei der in der Publikation Griswold et al, Generalized autocalibrating partially parallel acquisitions (GRAPPA), Magn Reson Med. 2002 Jun;47(6):1202-10 beschriebenen Technik) oder im Bildraum, z.B. z.B. bei der in der Publikation Pruessmann et al, SENSE: sensitivity encoding for fast MRI. Magn Reson Med. 1999 Nov;42(5):952-62 beschriebenen Techik, interpoliert.

Die Methode der parallelen Bildgebung birgt zwei Nachteile: zum einem verursacht das Unterabtasten eine Verringerung des Signal-zu-Rausch-Verhältnis (SNR), zum anderen wird das Rauschen zusätzlich um einen Faktor, der von der Spulengeometrie abhängt, verstärkt (sog. g-Faktor).

Im Gegensatz zur parallelen Bildgebung wird mit der simultanen Mehrschichtbildgebung (engl. simultaneous multi-slice, SMS) der Frequenzraum nicht unterabgetastet, sondern man nutzt spezielle HF-Pulse, um mehrere Schichten gleichzeitig anzuregen und zu messen. Die Signale der verschiedenen Schichten sind somit überlagert, können jedoch wiederum mit Hilfe der räumlichen Sensitivitätsprofile der Empfangsspulenelemente getrennt werden. Dazu kann man dedizierte GRAPPA-Kerne verwenden, wie sie aus der parallelen Bildgebung bekannt sind. Dieses Verfahren ist kombinierbar mit einer Unterabtastung entsprechend der parallelen Bildgebung (innerhalb der Schicht).

Mittels SMS hat man im Idealfall keinen SNR-Verlust durch Unterabtastung, aber immer noch eine Rauschverstärkung durch den g-Faktor. Ein weiterer Nachteil dieser Technik sind die Einschränkungen durch den benötigten Schichtabstand bzw. durch die Anzahl an Schichten: der Abstand simultan angeregter Schichten muss mindestens so groß sein wie eine charakteristische Längenskala der räumlichen Sensitivitätsprofile der Empfangsspulenelemente. SMS ist beispielsweise in der Publikation Larkman et al, Use of multicoil arrays for separation of signal from multiple slices simultaneously excited. J Magn Reson Imaging. 2001 Feb;13(2):313-7 beschrieben.

Die starke Abhängigkeit der simultanen Mehrschichtbildgebung von der Spulengeometrie (g-Faktor) kann mittels der in der Publikation Breuer et al. Controlled aliasing in volumetric parallel imaging (2D CAIPIRINHA). Magn Reson Med. 2006 Mar;55(3):549-56 beschriebenen Aufnahmetechnik verringert werden. Diese Aufnahmetechnik verursacht eine Verschiebung der Schichten, welche simultan aufgenommen werden.

Die Rekonstruktion erfolgt analog zur konventionellen SMS-Methode, nur dass jetzt auch die Verschiebung der Schichten beachtet werden muss. Diese Methode weist immer noch eine Sensitivität bezüglich der Spulengeometrie auf, jedoch kann die Rauschverstärkung reduziert werden.

Compressed Sensing (CS) ist eine Methode, die ebenfalls eine MRT-Aufnahme durch Unterabtastung beschleunigt. Diese Methode ist z.B. in der Publikation Lustig et al. Compressed sensing MRI. IEEE Signal Process Mag. 2008;25(2):72-82 beschrieben.

Im Gegensatz zur parallelen Bildgebung wird aber der Frequenzraum typischerweise nicht regelmäßig, sondern gezielt inkohärent (d.h. mittels eines zufälligen oder pseudozufälligen Musters) abgetastet. Dies verursacht starke Aliasingartefakte, welche sich als inkohärentes Rauschmuster über das eigentliche Signal legen. Üblicherweise werden die Daten zur Rekonstruktion in eine andere mathematische Domäne transformiert. Der Transformationsraum wird so gewählt, dass natürliche Bilddaten, z.B. eines Kopfes eines Patienten, darin mit nur wenigen Koeffizienten darstellbar sind, d.h. sie sind in diesem Raum "sparse"; ein Beispiel für eine Transformation mit diesen Eigenschaften ist die Wavelet-Transformation. Das ist äquivalent zur Aussage, dass das aufgenommene Signal komprimierbar ist (indem man die informationstragenden Koeffizienten in diesem Raum speichert anstatt des gesamten Bildes). Die Annahme ist, dass sich das Unterabtastungsartefakt auch im Transformationsraum als Rauschen niederschlägt. Vereinfacht gesagt, wird nun in der Compressed-Sensing-Rekonstruktion das Signal nach der Transformation iterativ entrauscht. Damit kann im Idealfall das Signal trotz unvollständiger Abtastung ohne Verluste wiederhergestellt werden, indem man die angenommene "Sparsity" im Transformationsraum erzwingt.

Der Nachteil dieser Methode ist, dass sich bei zu hoher Unterabtastung das Bild nur noch zunehmend verschwommen rekonstruieren lässt.

In der klinischen Routine kommen derzeit in der Regel zweidimensionale Aufnahmetechniken (beispielsweise die Turbo-Spin-Echo-Technik, TSE) zum Einsatz, bei denen die zu untersuchende Anatomie in einem Stapel zweidimensionaler Schichten aufgenommen und abgebildet wird. Solche zweidimensionaler Mehrschichtaufnahmen benötigen jedoch in der Regel eine recht lange Aufnahmezeit.

Vor diesem Hintergrund ist es eine Aufgabe der vorliegenden Erfindung, die lange Aufnahmezeit konventioneller Magnetresonanzmessungen zu verringern.

Die Aufgabe wird durch die Merkmale der unabhängigen Ansprüche gelöst. Vorteilhafte Ausgestaltungen sind in den abhängigen Ansprüchen beschrieben.

Demnach wird ein Verfahren zur Magnetresonanzmessung zumindest einer Gruppe simultan angeregter Schichten entlang einer Schichtachse vorgeschlagen. Dabei wird ein abzutastender Frequenzraumbereich in einem Frequenzraum mittels einer Systemsteuereinheit festgelegt. Der Frequenzraum kann auch als k-Raum, Impulsraum oder Ortsfrequenzraum bezeichnet werden. Hierbei wird eine erste Frequenzraumdimension einer ersten phasenkodierten Achse zugeordnet und eine zweite Frequenzraumdimension wird, einer zweiten phasenkodierten Achse zugeordnet, wobei die zweite phasenkodierte Achse der Schichtachse entspricht. Ferner wird mittels der Systemsteuereinheit für jede Gruppe der simultan angeregten Schichten ein mehrere Abtastpunkte umfassendes Unterabtastungsschema festgelegt. Dabei wird entlang der ersten Frequenzraumdimension und/oder zweiten Frequenzraumdimension eine unregelmäßige, unvollständige Abtastung des Frequenzraumbereichs vorgesehen. Zudem wird eine Magnetresonanzmessung der zumindest einen Gruppe der simultan angeregten Schichten entlang der Schichtachse gemäß dem jeweiligen Unterabtastungsschema - insbesondere durch Phasenkodierungen der ersten und der zweiten phasenkodierten Achse, die dem jeweiligen Unterabtastungsschema entsprechen - zur Akquisition von Magnetresonanzsignalen durchgeführt.

Die Systemsteuereinheit ist vorzugsweise eine Systemsteuereinheit einer Magnetresonanzvorrichtung. Die Systemsteuereinheit umfasst vorzugsweise eine Prozessoreinheit. Die Prozessoreinheit kann beispielsweis einen oder mehrere Prozessoren und/oder einen Datenspeicher umfassen.

Vorzugsweise werden bei der Magnetresonanzmessung Magnetresonanzsignale akquiriert. Dies kann beispielsweise mittels einer Hochfrequenzantenneneinheit der Magnetresonanzvorrichtung erfolgen. Anhand der akquiriert Magnetresonanzsignale können vorteilhafterweise eine oder mehrere Magnetresonanzabbildungen rekonstruiert werden. Die eine oder mehreren rekonstruierten Magnetresonanzabbildungen können auf einem Datenträger abgespeichert und/oder auf einem Anzeigeeinheit angezeigt werden.

Bei der Schichtachse kann es sich beispielsweise um eine Raumrichtung handeln, entlang der die zwei oder mehr Schichten angeordnet sind, die simultan angeregt werden sollen, so dass die Schichtachse senkrecht zu den jeweiligen Schichtebenen steht.

Die erste Achse kann beispielsweise einer Ortsraumdimension parallel zu den Schichtebenen, also senkrecht zu der Schichtachse, entsprechen. Dasselbe gilt gegebenenfalls für die dritte Achse.

Bei dem Frequenzraumbereich kann es sich insbesondere um einen dreidimensionalen Frequenzraumbereich oder einen zweidimensionalen Frequenzraumbereich, insbesondere Unterraumbereich des dreidimensionalen Frequenzraumbereichs, handeln. Im Falle eines dreidimensionalen Frequenzraumbereichs kann insbesondere eine dritte Frequenzraumdimension einer dritten phasenkodierten oder frequenzkodierten Achse zugeordnet werden, wobei die dritte Achse insbesondere senkrecht auf der ersten und der zweiten Achse steht.

Das Festlegen des abzutastenden Frequenzraumbereichs beinhaltet beispielsweise eine Festlegung einer Ausdehnung des abzutastenden Frequenzraumbereichs sowie eine Diskretisierung des Frequenzraumbereichs, also eine Festlegung von diskreten (Abtast-)Punkten, im Frequenzraum mit definierten Abständen entlang der zwei beziehungsweise drei Dimensionen des Frequenzraums.

Die Festlegung des abzutastenden Frequenzraumbereichs erfolgt beispielsweise basierend auf einem vordefinierten zu erfassenden Bildbereich im Ortsraum, auch Bildgröße genannt (engl. field of view, FOV). Die Festlegung des abzutastenden Frequenzraumbereichs kann beispielsweise unter Berücksichtigung oder Einhaltung des Sampling-Theorems, auch Nyquist-Theorem oder Nyquist-Shannon-Abtasttheorem genannt,

Die Diskretisierung des abzutastenden Frequenzraumbereichs kann beispielsweise derart erfolgen, dass ein Abstand zwischen zwei benachbarten diskreten Punkten im Frequenzraum entlang einer Frequenzraumdimension gerade dem Inversen einer Ausdehnung des FOV entlang der zugehörigen Ortsraumdimension entspricht. Das Festlegen des Frequenzraumbereichs kann beispielsweise zur Reduktion der Ausdehnung des abzutastenden Frequenzraumbereichs Symmetrien des Frequenzraums berücksichtigen.

Eine "phasenkodierte Achse" beziehungsweise "frequenzkodierte Achse" kann beispielsweise verstanden werden als Achse, entlang der während der Magnetresonanzmessung eine Ortskodierung realisiert wird, die einer Phasenkodierung beziehungsweise einer Frequenzkodierung entspricht.

Insbesondere können durch das Festlegen der Unterabtastungsschemata Koordinatenpaare bestimmt werden, welche jeweils einen der Abtastpunkte beschreiben, wobei jedes Koordinatenpaar eine erste Koordinate bezüglich der ersten Frequenzraumdimension, im Folgenden auch y-Koordinate bezeichnet, und eine zugehörige zweite Koordinate bezüglich der zweiten Frequenzraumdimension enthält, im Folgenden auch z-Koordinate bezeichnet.

Dass entlang einer Frequenzraumdimension eine unvollständige Abtastung vorgesehen wird, kann beispielsweise bedeuten, dass zumindest für einen Teil des abzutastenden Frequenzraumbereichs in dieser Frequenzraumdimension eine Abtastung von weniger (Abtast-)Punkten erfolgt, als dies für eine gemäß dem Sampling-Theorem vollständige Abtastung erforderlich wäre.

Dies kann beispielsweise bedeuten, dass es zumindest eine Frequenzraumkoordinate der ersten Frequenzraumdimension gibt, also zumindest eine Zeile entlang der Schichtachse, für die entweder weniger als die Hälfte aller Frequenzraumkoordinaten der zweiten Frequenzraumdimension abgetastet wird oder, sofern für diese Frequenzraumkoordinate der ersten Frequenzraumdimension zumindest zwei Frequenzraumkoordinaten der zweiten Frequenzraumdimension abgetastet werden, zwischen den beiden abgetasteten Frequenzraumkoordinaten der zweiten Frequenzraumdimension zumindest eine nicht abgetastete Frequenzraumkoordinate der zweiten Frequenzraumdimension liegt.

Durch die unvollständige Abtastung des Frequenzraumbereichs kann der Frequenzraumbereich besonders schnell abgetastet werden, so dass die Magnetresonanzmessung besonders schnell durchgeführt werden kann.

Dass entlang einer Frequenzraumdimension eine unregelmäßige Abtastung vorgesehen wird, kann beispielsweise bedeuten, dass die Abtastung in dieser Frequenzraumdimension inkohärent, zufällig, randomisiert und/oder pseudorandomisiert ist. Vorzugsweise ist die Unregelmäßigkeit der Abtastung dergestalt, dass die auf diese Weise abgetasteten Magnetresonanzsignale sich besonders gut für eine Compressed-Sensing-Rekonstruktion eignen. Durch eine Compressed-Sensing-Rekonstruktion können die dadurch rekonstruierten Magnetresonanzabbildungen eine hohe Qualität aufweisen, obwohl der Frequenzraumbereich nur unvollständig abgetastet wird.

Vorzugsweise wird sowohl entlang der ersten Frequenzraumdimension als auch entlang der zweiten Frequenzraumdimension eine unregelmäßige, unvollständige Abtastung des Frequenzraumbereichs vorgesehen.

Durch die Festlegung des Unterabtastungsschemas wird beispielsweise definiert, welche der diskreten Punkte des abzutastenden Frequenzraumbereichs abgetastet werden.

Durch die Festlegung des Unterabtastungsschemas wird also beispielsweise definiert, welche der diskreten Punkte des abzutastenden Frequenzraumbereichs abgetastet werden.

Bei dem Durchführen der (Multischicht-)Magnetresonanzmessung wird vorzugsweise das für die jeweilige Schichtgruppe festgelegte Unterabtastungsschema angewandt. Zur Anwendung des jeweiligen Unterabtastungsschemas werden vorzugsweise Phasenkodierungen der ersten und der zweiten phasenkodierten Achse durchgeführt, um die Abtastpunkte des jeweiligen Unterabtastungsschemas abzutasten.

Sollen beispielsweise insgesamt sechs Schichten gemessen werden, von denen jeweils drei Schichten simultan angeregt (und somit auch simultan gemessen) werden, können diese sechs Schichten in zwei Gruppen á drei Schichten aufgeteilt werden. Beispielsweise wird die erste der zwei Gruppen gemäß eines ersten Unterabtastungsschemas und die zweite der zwei Gruppen gemäß eines zweiten Unterabtastungsschemas gemessen. Jeder der zwei Unterabtastungsschemata sieht dabei üblicherweise eine spezifische Art der Phasenkodierung der ersten und der zweiten phasenkodierten Achse vor, um die gemäß dem Unterabtastungsschemata abzutastenden (Abtast-)Punkte abzutasten.

Durch eine simultane Anregung mehrerer Schichten mit unregelmäßiger Abtastung können insbesondere Vorteile der SMS-Technik mit Vorteilen der CS-Technik kombiniert werden, um die Aufnahmezeit der Magnetresonanzmessungen zu verringern. Ferner erlaubt das vorgeschlagene Verfahren eine systematische Bestimmung erforderlicher Gradientenmomente für die Durchführung der Magnetresonanzmessung, da jedem abzutastenden Punkt in allen Dimensionen des abzutastenden Frequenzraumbereichs in einer definierten Weise Frequenzraumkoordinaten zugewiesen werden können. Da die Gradientenmomente gerade der gezielten Verschiebung der Frequenzraumkoordinaten zwischen einzelnen Schritten der Magnetresonanzmessung dienen, sind diese systematisch, universell und flexibel bestimmbar.

Vorzugsweise variiert die Dichte der Abtastpunkte im abzutastenden Frequenzraumbereich, insbesondere in Abhängigkeit von ihrem Abstand zum Zentrum des abzutastenden Frequenzraumbereichs.

Beispielsweise kann die Dichte der Abtastpunkte im Zentrum des abzutastenden Frequenzraumbereich höher sein als in der Peripherie des Frequenzraumbereichs. Dadurch kann ein guter Kontrast einer Magnetresonanzabbildung erreicht werden, obwohl der Frequenzraumbereich nur unvollständig abgetastet wird.

Eine weitere Ausführungsform des Verfahrens zur Magnetresonanzmessung sieht vor, dass im Frequenzraum ein Referenzobjekt festgelegt wird, wobei für jeden Abtastpunkt jeweils ein Abstand von dem Abtastpunkt zum Referenzobjekt ermittelt wird. Die Abtastpunkte werden dann in einer zeitlichen Abfolge abgetastet, die abhängig ist von ihren Abständen zum Referenzobjekt.

Das Referenzobjekt ist vorzugsweise ein Referenzobjekt im Frequenzraum. Das Referenzobjekt kann insbesondere ganz oder teilweise im abzutastenden Frequenzraumbereich liegen. Das Referenzobjekt kann insbesondere eine geometrische Struktur umfassen, beispielsweise zumindest eine Referenzkurve und/oder zumindest ein Referenzpunkt.

Vorzugsweise wird eine Reihenfolge von Abtastpunkten ermittelt, indem die Abtastpunkte gemäß ihren Abständen zu einem Referenzobjekt in Form eines Referenzpunktes in die Reihenfolge einsortiert werden. Insbesondere können Koordinatenpaare anhand des jeweiligen Abstands des durch das Koordinatenpaar beschriebenen Abtastpunkts zum Referenzpunkt in die Reihenfolge sortiert werden.

Beispielsweise werden zunächst Abtastpunkte mit größeren Abständen zum Referenzpunkt abgetastet, d.h. die Abtastpunkte werden mit absteigenden Abständen in die Reihenfolge einsortiert. Alternativ können auch zunächst Abtastpunkte mit kleineren Abständen zum Referenzpunkt abgetastet werden, d.h. die Abtastpunkte werden mit aufsteigenden Abständen in die Reihenfolge einsortiert.

Im einfachsten Fall werden beim Durchführen der Magnetresonanzmessung die Abtastpunkte nacheinander in der ermittelten Reihenfolge abgetastet, d.h. die zeitliche Abfolge, in der die Abtastpunkte abgetastet werden, entspricht der ermittelten Reihenfolge. Es ist jedoch auch möglich, dass die ermittelte Reihenfolge segmentiert wird. Dadurch kann die zeitliche Abfolge der Abtastung der Abtastpunkte gegenüber der ermittelten Reihenfolge der Abtastpunkte verändert werden.

Vorzugsweise werden die Abtastpunkte in Segmente eingeteilt, und die Abtastpunkte eines Segments werden abhängig von ihren Abständen zum Referenzobjekt in jeweils eine Reihenfolge sortiert. Dies kann beispielsweise bei einer segmentierten Abtastung des Frequenzraumbereichs vorteilhaft sein.

Durch die Abtastung in einer abstandsabhängigen Reihenfolge kann die Gewichtung des Kontrastes der Magnetresonanzabbildungen, die aus den mit Hilfe der Abtastung akquirierten Magnetresonanzsignalen erzeugt werden können, gezielt beeinflusst werden. Dies gilt insbesondere dann, wenn das Referenzobjekt ein Referenzpunkt im Zentrum des abzutastenden Frequenzraumbereichs ist.

Vorzugsweise befindet sich das Referenzobjekt im Zentrum oder an einem Rand des abzutastenden Frequenzraumbereichs. Das Zentrum des abzutastenden Frequenzraumbereichs wird oftmals auch als das k-Raum-Zentrum bezeichnet. Im k-Raum-Zentrum ist üblicherweise die wesentlichen Kontrastinformationen einer Magnetresonanzabbildung situiert, während die Peripherie des k-Raum vor allem Ortsinformationen, wie z.B. Kanten, enthält. Ist beispielsweise das Referenzobjekt ein Referenzpunkt im Zentrum des abzutastenden Frequenzraumbereichs, kann im Rahmen einer Turbo-Spin-Echo- (TSE-) Sequenz mit einer Abtastung vom Zentrum beginnend nach außen (also bei einer Reihenfolge mit ansteigendem Abstand zum Zentrum) eine Protonendichte-(PD-) gewichtete Magnetresonanzabbildung bzw. ein PD-Kontrast erzeugt werden. Alternativ kann mit einer Abtastung von außen beginnend nach innen (also bei einer Reihenfolge mit abfallendem Abstand zum Zentrum) eine T2-gewichtete Magnetresonanzabbildung bzw. ein T2-Kontrast erzeugt werden. Dies beruht darauf, dass aufgrund von Relaxationseinflüssen mit einer längeren Echozeit TE der Kontrast von einer PD-Wichtung zu einer T2-Wichtung übergeht. Daher kann es von Vorteil sein, das Abtastschema derart zu adaptieren, dass ein gewünschter Kontrast erzielt wird.

Vorzugsweise ist der besagte Abstand von dem Abtastpunkt zum Referenzobjekt, insbesondere Referenzpunkt, ein kartesischer Abstand zum Referenzobjekt oder ein Abstand zum Referenzobjekt mit unterschiedlicher Gewichtung hinsichtlich der ersten Frequenzraumdimension und der zweiten Frequenzraumdimension.

Ist beispielsweise das Referenzobjekt ein Referenzpunkt R, kann der Abstand D eines Abtastpunkts P zum Referenzpunkt R berechnet werden mit

$$D = \sqrt{a \cdot \left(k_{y,P} - k_{y,R}\right)^2 + b \cdot \left(k_{z,P} - k_{z,R}\right)^2}$$

Dabei ist

- $k_{y,P}$ die Koordinate des Abtastpunkts P in der ersten Frequenzraumdimension $k_y$,
- $k_{z,P}$ die Koordinate des Abtastpunkts P in der zweiten Frequenzraumdimension $k_z$,
- $k_{y,R}$ die Koordinate des Referenzpunkts R in der ersten Frequenzraumdimension $k_y$,
- $k_{z,R}$ die Koordinate des Referenzpunkts R in der zweiten Frequenzraumdimension $k_z$,
- a ein Gewichtungsfaktor hinsichtlich der ersten Frequenzraumdimension $k_y$ und
- b ein Gewichtungsfaktor hinsichtlich der zweiten Frequenzraumdimension $k_z$.

Für den Fall, dass a=b=1 ist, entspricht der Abstand D einem kartesischen Abstand mit gleichmäßiger Gewichtung hinsichtlich der der ersten Frequenzraumdimension und der zweiten Frequenzraumdimension. Für den Fall, dass a≠b ist, wird der Abstand hinsichtlich der ersten Frequenzraumdimension und der zweiten Frequenzraumdimension unterschiedlich gewichtet.

Eine weitere Ausführungsform des Verfahrens zur Magnetresonanzmessung sieht vor, dass die Abtastpunkte gemäß einer Segmentierung abgetastet werden.

Insbesondere kann die Segmentierung gemäß einem Segmentierungsschema erfolgen. Das Segmentierungsschema entspricht beispielsweise einer Zuordnung von Aufnahmezeiträumen zu einem oder mehreren Anregungspulsen und/oder zu einem oder mehreren Echos eines Echozuges in Folge eines Anregungspulses.

Entsprechend kann das Segmentierungsschema durch einen oder mehrere Segmentierungsindizes gekennzeichnet oder definiert sein. Die Segmentierungsindizes können beispielsweise einen Echoindex enthalten, welcher für einen gegebenen Anregungspuls die zugehörigen Aufnahmezeiträume durchnummeriert und/oder indiziert. Die Segmentierungsindizes können auch einen Anregungsindex enthalten, insbesondere wenn mehrere Anregungspulse appliziert werden. Der Anregungsindex indiziert oder nummeriert dann beispielsweise die verschiedenen Anregungspulse.

Bei dem Anregungspuls handelt es sich insbesondere um einen Hochfrequenzpuls, der dazu dient, Kernspins um einen Winkel, insbesondere einen Ernst-Winkel, beispielsweise um 90°, insbesondere aus einer Ausrichtung entlang der Schichtachse heraus zu kippen.

Jeder Aufnahmezeitraum kann also eindeutig einem Tupel von Segmentierungsindizes, im Folgenden als Segmentierungstupel bezeichnet, zugeordnet sein, wobei das Segmentierungstupel ein 1-tupel, ein 2-tupel, etc. sein kann, je nach Komplexität des Segmentierungsschemas.

Durch die Zuordnung der Aufnahmezeiträume zu den Segmentierungsindizes wird eine zeitliche Abfolge der Aufnahmezeiträume derart definiert, dass eine zeitliche Abfolge der Aufnahmezeiträume einer Abfolge der Segmentierungsindizes entsprechen. Bei nur einem Index entspricht die Abfolge beispielsweise direkt dem Index. Bei zwei Indizes definiert beispielsweise einer der Indizes eine Reihenfolge von Gruppen von Aufnahmezeiträumen, und ein zweiter Index definiert eine Reihenfolge innerhalb der jeweiligen Gruppen. Analog lässt sich dies für mehrere Indizes fortführen.

Aufgabe der Segmentierungen kann es sein, einen gewünschten Kontrast zu generieren, der durch die Signalamplituden der verschiedenen Gewebetypen zum Zeitpunkt der Aufnahme des k-Raum-Zentrums wesentlich beeinflusst wird. Beispielsweise können die aufzunehmenden Abtastpunkte auf mehrere Anregungen einer TSE-Sequenz verteilt werden. Ferner können Segmentierungen eingesetzt werden, um lange Signal-Evolutionszeiten zu vermeiden. Letztere können zu Signalverlust führen, beispielsweise durch Relaxationseffekte und/oder Akkumulation unerwünschter Signalphasen, beispielsweise aufgrund nichtidealer Aufnahmebedingungen.

Gemäß zumindest einer Ausführungsform wird jeder Aufnahmezeitraum gemäß dem Segmentierungsschema einem Anregungspuls und/oder einem Echo eines Echozugs zugeordnet. Insbesondere kann der zumindest eine Segmentierungsindex einen Anregungsindex einer Abfolge von Anregungspulsen und/oder ein Echoindex eines Echos eines Echozuges in Folge eines Anregungspulses umfassen.

Gemäß zumindest einer Ausführungsform wird zur Durchführung der Magnetresonanzmessung jeder Abtastpunkt (bzw. das diesen beschreibende Koordinatenpaar) genau einem Tupel von Segmentierungsindizes zugeordnet, um eine Abfolge einer Abtastung der Koordinatenpaare während der Magnetresonanzmessung zu definieren. Durch die Zuordnung eines Abtastpunkt zu einem Segmentierungstupel wird folglich der Abtastpunkt auch genau einem Aufnahmezeitraum zugeordnet.

Durch die Zuordnung der Abtastpunkte (bzw. der sie beschreibenden Koordinatenpaare) zu den Segmentierungstupeln ist eine Reihenfolge der Abtastung der verschiedenen y- und z-Koordinaten im Frequenzraumbereich definiert.

In einer weiteren Ausführungsform des Verfahrens wird jedem Abtastpunkt zumindest ein Segmentierungsindex in Abhängigkeit von dem Abstand der Abtastpunkte zum Referenzobjekt, insbesondere eindeutig, zugeordnet. Insbesondere erfolgt die Zuordnung des zumindest einen Segmentierungsindex auf Basis einer ermittelten Reihenfolge von Abtastpunkten, in welche Reihenfolge die Abtastpunkte gemäß ihrer Abständen zu einem Referenzobjekts einsortiert werden.

Vorzugsweise wird jedem Abtastpunkt gemäß einer Zuordnungsvorschrift zumindest ein Segmentierungsindex eindeutig zugeordnet, wobei die Zuordnungsvorschrift eine Zuordnung zwischen der Segmentierung und dem Abstand der Abtastpunkte zum Referenzobjekt beschreibt.

Insbesondere wird gemäß der Zuordnungsvorschrift jedem Abtastpunkt ein Tupel von Segmentierungsindizes zugeordnet. Die Akquisition der Magnetresonanzsignale erfolgt vorteilhafterweise unter Berücksichtigung dieser Zuordnung.

Insbesondere werden zur Durchführung der Magnetresonanzmessung Magnetresonanzsignale während zugehöriger Aufnahmezeiträume aufgenommen und jedem Aufnahmezeitraum zumindest ein Segmentierungsindex, insbesondere ein Anregungsindex einer Abfolge von Anregungspulsen und/oder ein Echoindex eines Echos eines Echozuges in Folge eines Anregungspulses, eindeutig zugeordnet.

Vorzugsweise wird jedem Abtastpunkt genau ein Tupel aus Segmentierungsindizes zugeordnet, um die Abfolge der Abtastung der Abtastpunkte während der Magnetresonanzmessung festzulegen.

Vorzugsweise wird, insbesondere während der Magnetresonanzmessung, zwischen Abtastungen zweier gemäß der Abfolge aufeinanderfolgenden Abtastpunkte wenigstens ein Gradientenmoment appliziert, dessen Wert aus wenigstens einer Impulsdifferenz zwischen den aufeinanderfolgenden Abtastpunkten bestimmt wird.

Weisen die Koordinatenpaare aufeinanderfolgender Abtastpunkte beispielsweise unterschiedliche y-Koordinaten auf, so ergibt sich ein y-Gradientenmoment unmittelbar aus der Differenz zwischen den y-Koordinaten der aufeinanderfolgenden Koordinatenpaare. Insbesondere ist das y-Gradientenmoment gegeben durch einen Impulsunterschied in y-Richtung der aufeinanderfolgende Koordinatenpaare geteilt durch das gyromagnetische Verhältnis.

Weisen die Koordinatenpaare aufeinanderfolgender Abtastpunkte beispielsweise unterschiedliche z-Koordinaten auf, ergibt sich ein zu applizierendes z-Gradientenmoment unmittelbar aus der Impulsdifferenz in z-Richtung der aufeinanderfolgenden Koordinatenpaare. Insbesondere ist das z-Gradientenmoment gegeben durch den Impulsunterschied in z-Richtung der aufeinanderfolgenden Koordinatenpaare geteilt durch das gyromagnetische Verhältnis.

Durch die Definition der Gradientenmomente wird ein Abtastpfad und/oder eine Abtastroute innerhalb des abzutastenden Frequenzraumbereichs ermöglicht.

Eine weitere Ausführungsform des Verfahrens zur Magnetresonanzmessung sieht vor, dass die zumindest einer Gruppe simultan angeregter Schichten mehrere Gruppen simultan angeregter Schichten sind (d.h. es wird nicht nur eine Schichtgruppe gemessen, sondern mehrere) und die Unterabtastungsschemata der mehreren Gruppen der simultan angeregten Schichten identisch sind oder sich voneinander unterscheiden.

Ein Vorteil identischer Schemata für alle Gruppen simultan aufzunehmender Schichten kann insbesondere in einer einfachen technischen Realisierung bestehen. Ein Vorteil unterschiedlicher Schemata kann in einer Erhöhung ihrer Inkohärenz bestehen, da eine periodische Wiederholung der Schemata vermieden wird. Die Inkohärenz kann sich vorteilhaft auf eine Compressed-Sensing- (CS-) Rekonstruktion auswirken.

Eine weitere Ausführungsform des Verfahrens zur Magnetresonanzmessung sieht vor, dass die Magnetresonanzsignale mittels einer iterativen Rekonstruktionstechnik, insbesondere mittels einer CS-Technik, rekonstruiert werden.

Durch die unregelmäßige, unvollständige Abtastung des Frequenzraumbereich kann die CS-Technik besonders vorteilhaft eingesetzt werden. Durch die unregelmäßige Abtastung können hiermit Artefakte in den Magnetresonanzabbildungen weitgehend vermieden werden, obwohl der Frequenzraumbereich nur unvollständig - aber somit schnell - abgetastet wird.

Insbesondere können bei einer unvollständigen, unregelmäßigen Abtastung entlang zumindest zweier k-Raum-Dimensionen, wobei davon eine k-Raum-Dimension einer Schicht-Kodierungsrichtung einer simultanen Mehrschichtaufnahme entspricht, Magnetresonanzsignale akquiriert werden, die sich besonders gut Rekonstruktion mittels einer CS-Technik eignen.

Vorzugsweise umfasst die iterativen Rekonstruktionstechnik, insbesondere die CS-Technik, eine Regularisierung der Magnetresonanzsignale entlang der zweiten Frequenzraumdimension. Bei unregelmäßiger Abtastung entlang der zweiten Frequenzraumdimension, also entlang der Schichtrichtung, können periodische Unterabtastungsartefakte weitgehend vermieden werden.

Eine weitere Ausführungsform des Verfahrens zur Magnetresonanzmessung sieht vor, dass die Akquisition der Magnetresonanzsignale mittels mehrerer Spulenelemente erfolgt, wobei Empfangsprofile der Spulenelemente erfasst und die Magnetresonanzsignale unter Berücksichtigung der Empfangsprofile der Spulenelemente rekonstruiert werden.

Insbesondere mit Hilfe der Empfangsprofile der Spulenelemente kann der abgetastete Frequenzraumbereich mit einer konventionellen CS-Rekonstruktion in den Bildraum transformiert werden.

Die Empfangsprofile der Spulenelemente können beispielsweise auf Basis einer zusätzlichen, schnellen Kalibrierungsmessung (beispielsweise eine Multi-Schicht-Gradientenecho-Messung mit niedriger Auflösung, kurzer Echo- (TE) und Wiederholungszeit (TR)) berechnet werden.

Ferner ist denkbar, dass die Magnetresonanzsignale mittels eines neuronalen Netzwerkes rekonstruiert werden.

Vorzugsweise wird die Magnetresonanzmessung gemäß einer der folgenden Sequenztypen durchgeführt:

- Turbo Spin-Echo (TSE)
- Single-Shot Echo-Planar-Imaging (ss-EPI),
- Multi-Shot Echo-Planar-Imaging (ms-EPI),
- Gradient Recalled Echo (GRE),
- Gradient and Spin Echo (GRASE),
- Fast Imaging with Steady State Precession (FISP).

Ferner wird eine Magnetresonanzvorrichtung vorgeschlagen, die ausgebildet ist, ein vorab beschriebenes Verfahren zur Magnetresonanzmessung auszuführen. Die Vorteile einer solchen Magnetresonanzvorrichtung entsprechen im Wesentlichen den Vorteilen des vorab beschriebenen Verfahrens zur Magnetresonanzmessung. Vorzugsweise weist die Magnetresonanzvorrichtung eine Systemsteuereinheit zur Durchführung des Verfahrens auf.

Ferner wird ein Computerprogrammprodukt vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein erfindungsgemäßes Verfahren auszuführen, wenn das Computerprogrammprodukt in der Systemsteuereinheit der Magnetresonanzvorrichtung ausgeführt wird. Das Computerprogrammprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist.

Durch das Computerprogrammprodukt kann das erfindungsgemäße Verfahren schnell, identisch wiederholbar und robust ausgeführt werden. Das Computerprogrammprodukt ist so konfiguriert, dass es mittels der Systemsteuereinheit erfindungsgemäße Verfahrensschritte ausführen kann. Die Systemsteuereinheit weist vorzugsweise dabei jeweils die Voraussetzungen wie beispielsweise einen entsprechenden Arbeitsspeicher, eine entsprechende Grafikkarte oder eine entsprechende Logikeinheit auf, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein erfindungsgemäßes Verfahren durchführen.

Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Systemsteuereinheit der Magnetresonanzvorrichtung gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1    eine Magnetresonanzvorrichtung in einer schematischen Darstellung,

Fig. 2    ein Flussdiagramm eines Verfahrens zur Magnetresonanzmessung zumindest einer Gruppe simultan angeregter Schichten entlang einer Schichtachse,

Fig. 3    ein Abtastschema gemäß dem Stand der Technik,

Fig. 4-6    Unterabtastungsschemata eines Frequenzraumbereichs,

Fig. 7    eine abstandsabhängige Segmentierung eines Unterabtastungsschemas,

Fig. 8    ein Schema des zeitlichen Ablaufs einer TSE-Sequenz.

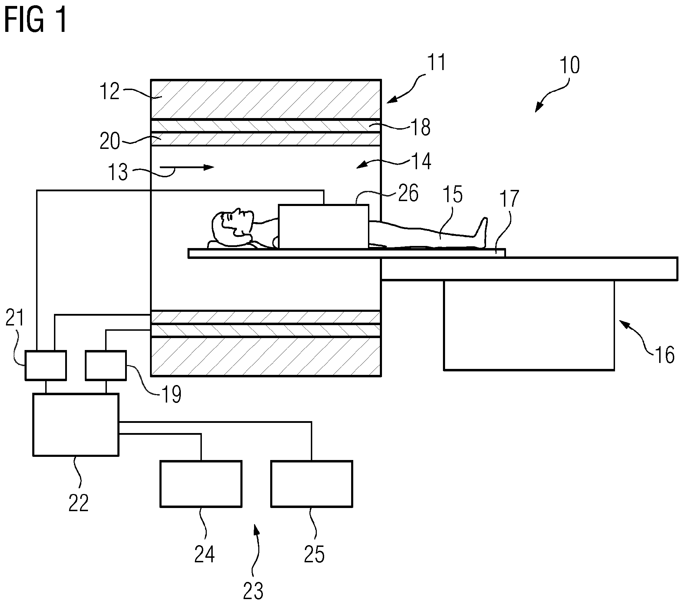

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 umfasst weiterhin eine Gradientenspuleneinheit 18 zu einer Erzeugung von Magnetfeldgradienten (im zeitlichen Ablauf oft auch Gradientenpulse genannt mit den sich daraus ergebenden Gradientenmomenten), die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 ist ausgelegt, während einer Magnetresonanzmessung hochfrequente Anregungspulse zu erzeugen. Diese bewirken eine Anregung von Atomkernen des Patienten 15, die sich in dem von dem Hauptmagneten 12 erzeugten Hauptmagnetfeld 13 einstellt. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in einen Untersuchungsraum ein, der im Wesentlichen von einem Patientenaufnahmebereich 14 der Magnetresonanzvorrichtung 10 gebildet ist. Die Hochfrequenzantenneneinheit 20 ist weiterhin zum Empfang von Magnetresonanzsignalen ausgebildet. Die Magnetresonanzvorrichtung umfasst ferner eine Lokalspule 26, die in unmittelbarer Nähe zum Patienten 15 angeordnet ist. Die Lokalspule 26 umfasst mehrere Spulenelemente, die insbesondere zum Empfang von Magnetresonanzsignalen ausgebildet sind.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten Sequenz. Zudem umfasst die Systemsteuereinheit 22 eine nicht näher dargestellte Auswerteeinheit zu einer Rekonstruktion der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Magnetresonanzsignale werden üblicherweise in einem durch Gradientenmomente $M_{x/y/z}$ definierten inversen Raum, auch Frequenzraum, Impulsraum oder k-Raum genannt, aufgenommen. Für die Frequenzraumkoordinaten gilt $k_{x/y/z} = \gamma \int dt\, G_{x/y/z}(t)$, wobei $\gamma$ das gyromagnetische Verhältnis bezeichnet und das Zeitintegral über die ab dem Zeitpunkt der Anregung transversaler Magnetisierung applizierten Gradientenamplituden $G_{x/y/z}$ berechnet wird. Aus den für die Frequenzraumkoordinaten aufgenommenen Daten lassen sich dann per Fourier-Transformation die Bilder in den Ortsraumkoordinaten berechnen.

Eine Diskretisierung der aufgenommenen Magnetresonanzsignale kann beispielsweise durch eine Kammfunktion beschrieben werden, also über eine Summe aus inkrementell verschobenen Dirac-Funktionen. Eine vollständige Abtastung eines Ortsraumbereichs der Ausdehnung $FOV_i$ mit einer Auflösung von $N_i$-Punkten erfordert ein Inkrement $\Delta k_i = 1/FOV_i$. Auf diese Weise sind Signalbeiträge von Spins im Abstand $FOV_i$ gerade um $2\pi$ gegeneinander verschoben, und alle Positionen innerhalb $FOV_i$ weisen eine eindeutig zuordenbare Phase auf.

Durch optionale Überabtastung mit einem Überabtastungsfaktor $OS_i$ (0 entspricht keiner Überabtastung, 1 entspricht 100% Überabtastung) ergibt sich

$\Delta k_i = 1/(FOV_i*(1+OS_i))$.

In der Magnetresonanzbildgebung werden für eine Ortskodierung innerhalb der Schichtebene (beispielsweise x-y-Ebene) Frequenzkodierungen und/oder Phasenkodierungen verwendet, beispielsweise eine Frequenzkodierung entlang der x-Achse und eine Phasenkodierung entlang der y-Achse.

Für die Phasenkodierung wird vor der Datenaufnahme ein, beispielsweise konstantes, Magnetfeld mit einer definierten, beispielsweise linearen, Ortsabhängigkeit für eine festgelegte Zeitdauer geschaltet. Durch Schalten von Gradienten mit beispielsweise unterschiedlichen Zeitdauern und/oder Gradientenamplituden können die benötigten Impulsraumkoordinaten realisiert werden.

Für eine Frequenzkodierung wird während der Datenaufnahme ein, beispielsweise konstantes, Magnetfeld mit definierter, beispielsweise linearer, Ortsabhängigkeit geschaltet. In einem bestimmten zeitlichen Abstand aufeinanderfolgend aufgenommene Datenpunkte unterscheiden sich dann gerade durch ein Frequenzrauminkrement, welches durch den zeitlichen Abstand multipliziert mit dem gyromagnetischen Verhältnis und der entsprechenden Gradientenamplitude gegeben ist. Durch eine geeignete Wahl von Gradientenamplitude und zeitlichem Abstand lässt sich ein Frequenzrauminkrement realisieren, das dem gewünschten FOV und OS entspricht. Ein optionales zusätzliches Gradientenmoment vor der Datenaufnahme (Präphasierungsmoment) kann für die passenden initialen Impulsraumkoordinaten sorgen.

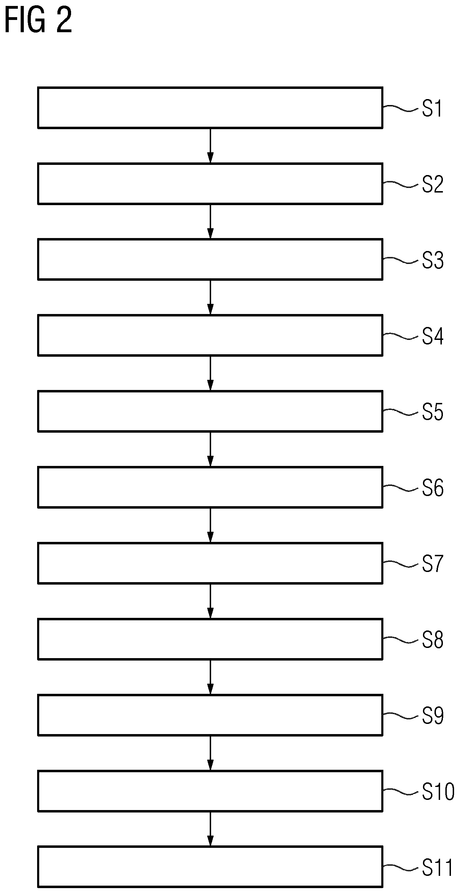

In Fig. 2 ist Verfahren zur Magnetresonanzmessung zumindest einer Gruppe simultan angeregter Schichten entlang einer Schichtachse schematisch dargestellt.

In S1 wird ein abzutastender Frequenzraumbereichs in einem Frequenzraum, insbesondere einem $k_y$-$k_z$-Raum, festgelegt, wobei eine erste Frequenzraumdimension $k_y$ einer ersten phasenkodierten Achse zugeordnet wird und eine zweite Frequenzraumdimension $k_z$ einer zweiten phasenkodierten Achse zugeordnet wird. Dabei entspricht die zweite phasenkodierte Achse der Schichtachse.

Insbesondere werden gemäß Nyquist-Shannon-Abtasttheorem vollständig abzutastenden $k_y$-$k_z$-Koordinaten im $k_y$-$k_z$-Raum festgelegt, wobei die $k_z$-Koordinaten eine SMS-Kodierung kennzeichnet.

Eine SMS-Kodierung unterscheidet sich von einer konventionellen Phasenkodierung entlang einer Achse dadurch, dass eine zusätzliche Ortskodierung durch die Anregung mehrerer Schichten in einem Abstand erfolgt. Bei einer konventionellen Phasenkodierung (beispielsweise bei dreidimensionaler MR-Bildgebung) wird ein kontinuierlicher Raumbereich angeregt und dann - gemäß der gewünschten Auflösung - im Frequenzraum abgetastet. Bei einer SMS-Phasenkodierung wird ein fragmentierter Raumbereich angeregt und dann - gemäß der durch die simultan angeregten Schichten vorgegebenen Auflösung - im Frequenzraum abgetastet.

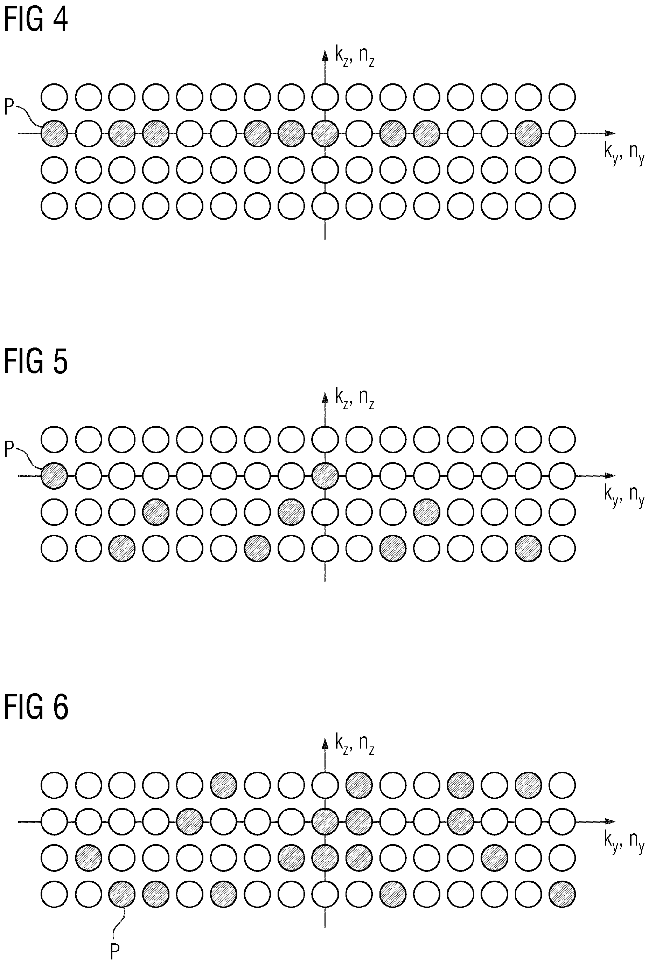

In S2 wird ein mehrere Abtastpunkte P umfassendes Unterabtastungsschema für jede Gruppe der simultan angeregten Schichten festgelegt, wobei entlang der ersten Frequenzraumdimension $k_y$ und/oder zweiten Frequenzraumdimension $k_z$ eine unregelmäßige, unvollständige Abtastung des Frequenzraumbereichs vorgesehen wird. (Beispielhafte Unterabtastungsschemata sind in den Fig. 4 bis 6 dargestellt.)

Insbesondere werden für jede Gruppe der simultan angerechten Schichten ein Unterabtastungsschema unter CS-Gesichtspunkten festgelegt und abzutastende Paare von $k_y$-$k_z$-Koordinaten bestimmt.

In S3 wird im Frequenzraum, insbesondere im $k_y$-$k_z$-Raum, ein Referenzobjekt R festgelegt. Das Referenzobjekt R kann beispielsweise zumindest eine Referenzlinie und/oder ein zumindest ein Referenzpunkt sein. Das Referenzobjekt R kann sich beispielsweise im Zentrum oder an einem der Ränder des abzutastenden Frequenzraumbereichs befinden.

In S4 wird für jeden Abtastpunkt P jeweils ein Abstand D von dem Abtastpunkt P zum Referenzobjekt R ermittelt. Der Abstand D kann beispielsweise ein kartesischer Abstand und/oder ein Abstand mit unterschiedlicher Gewichtung von $k_y$ und $k_z$ sein.

In S5 werden die Abtastpunkte P, insbesondere die aufzunehmenden $k_y$-$k_z$-Koordinaten, gemäß des jeweiligen Abstands D in einer Liste sortiert.

In S6 wird eine, insbesondere mehrfache, Segmentierung festgelegt. Insbesondere werden Segmentierungsindizes festlegt, beispielsweise ein Anregungsindex $I_A$ und/oder ein Echoindex $I_E$.

In S7 wird eine Zuordnungsvorschrift zwischen der Segmentierung und dem Abstand D festgelegt. Beispielsweise werden die Abtastpunkte P mit dem kleinsten Abständen D dem ersten Echoindex $I_E$ zugeordnet etc.

In S8 wird jedem Abtastpunkt P gemäß der Zuordnungsvorschrift zumindest ein Segmentierungsindex $I_A$, $I_E$ eindeutig zugeordnet, wobei die Zuordnungsvorschrift eine Zuordnung zwischen dem zumindest einen Segmentierungsindex $I_A$, $I_E$ und dem Abstand der Abtastpunkte P zum Referenzobjekt R beschreibt. Insbesondere wird jede $k_y$-$k_z$-Koordinate zu einem Tupel von Segmentierungs-Indizes gemäß Zuordnungsvorschrift zugeordnet.

Die Schritte S1 bis S8 können durch die Systemsteuereinheit 22 durchgeführt werden. Dazu kann in der Systemsteuereinheit 22 ein Computerprogrammprodukt hinterlegt sein. Das Computerprogrammprodukt kann ein Programm umfassen und direkt in einen Speicher einer programmierbaren Systemsteuereinheit 22 ladbar sein, mit Programmmitteln, um insbesondere die Schritte S1 bis S8 auszuführen, wenn das Programm in der Systemsteuereinheit 22 ausgeführt wird.

In S9 wird eine Magnetresonanzmessung der zumindest einen Gruppe der simultan angeregten Schichten entlang der Schichtachse gemäß dem jeweiligen Unterabtastungsschema durchgeführt. Dabei werden Magnetresonanzsignalen unter Berücksichtigung der zuvor erfolgten Zuordnung akquiriert. Insbesondere werden dabei die Abtastpunkte P in einer zeitlichen Abfolge abgetastet, die von den Abständen der Abtastpunkte P zum Referenzobjekt R abhängig ist. Die Magnetresonanzmessung kann beispielsweise gemäß einer TSE-, ss-EPI-, ms-EPI, GRE-, GRASE- oder FISP-Sequenz durchgeführt werden. Die Akquisition der Magnetresonanzsignale kann beispielsweise mittels der Lokalspule 26 erfolgen, die mehrere Spulenelemente aufweist.

In S10 können die Magnetresonanzsignale mittels einer iterativen Rekonstruktionstechnik, insbesondere mittels einer Compressed-Sensing-Technik, zu einer oder mehreren Magnetresonanzabbildungen rekonstruiert werden. Die Rekonstruktion kann insbesondere eine Regularisierung der Magnetresonanzsignale entlang der zweiten Frequenzraumdimension $k_z$ umfassen. Die Rekonstruktion kann insbesondere mittels der Empfangsprofile der Spulenelemente erfolgen. Die Empfangsprofile können basierend auf einer zusätzlichen, schnellen Kalibrierungsmessung (beispielsweise eine Multi-Schicht-Gradientenecho- Messung mit niedriger Auflösung und/oder kurzer Echo- (TE) und Wiederholungszeit (TR)) berechnet werden.

In S11 können die eine oder mehreren generierten Magnetresonanzabbildungen angezeigt werden, z.B. auf der Anzeigeeinheit 24 der Magnetresonanzvorrichtung 10.

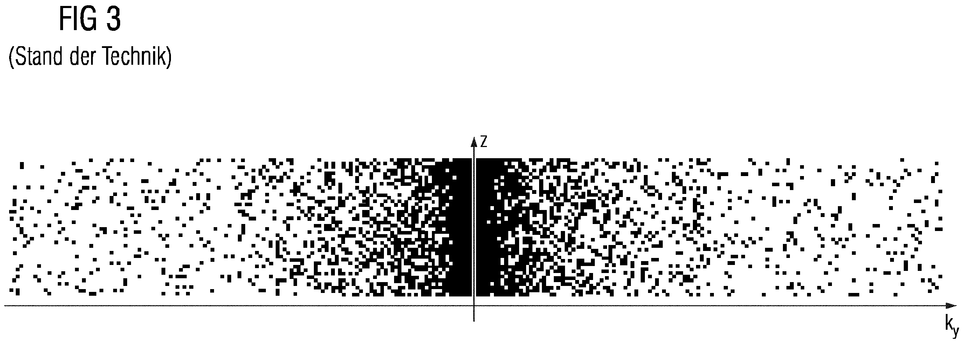

In Fig. 3 ist ein beispielhaftes Abtastschema gemäß dem Stand der Technik für eine zweidimensionale Compressed-Sensing-Aufnahme dargestellt, wobei die horizontale Achse den Frequenzraum entlang der y-Achse mit 270 Phasenkodierschritten darstellt und die vertikale Achse 40 Schichten entlang der z-Achse im Ortsraum (Schichtachse) zeigt.. Ein schwarzer Punkt entspricht einer Frequenzkodierung (Abtastung) und der weiße Zwischenraum entspricht k-Raum-Punkten, die für die jeweilige Schicht nicht abgetastet werden.

Eine solche Aufnahme kann mit einer SMS-Technik kombiniert werden, indem (beispielsweise durch die Hochfrequenzantenneneinheit 20) Anregungspulse erzeugt werden, die simultan mehrere Schichten anregen, und der k-Raum in einer Phasenkodierrichtung $k_y$ unregelmäßig mit variabler Dichte abgetastet wird.

In den Fig. 4 bis 6 ist jeweils ein k-Raum dargestellt mit einer phasenkodierten $k_y$-Achse, die einer ersten Frequenzraumdimension zugeordnet wird, und einer phasenkodierten $k_z$-Achse, die einer zweiten Frequenzraumdimension zugeordnet wird. Dabei entsprechen die $k_y$-Achse einer Impulsrichtung innerhalb einer Schichtebene und die $k_z$-Achse einer Impulsrichtung entlang der Schichtachse. Daher kann die $k_z$-Achse hier auch als $k_{sms}$-Achse bezeichnet werden, da die z-Koordinate einer verallgemeinerten SMS-Kodierung entspricht.

Die Koordinaten der $k_y$- bzw. $k_z$-Achse können auch mittels k-Raum-Inkrementen $\Delta k_y$ bzw. $\Delta k_z$ darge-

stellt werden mit $k_y = n_y * \Delta k_y$ bzw. $k_z = n_z * \Delta k_z$, wobei $n_y$ und $n_z$ ganzzahlig sind; somit können die Achsen auch als $n_y$- bzw. $n_z$-Achsen aufgefasst werden.

Die Zahlen $n_y$ und $n_z$ nummerieren also die entsprechenden Koordinaten entlang der $k_y$- und $k_z$-Achse durch. Die Anzahl der möglichen Abtastpunkte entlang der Achsen sowie der tatsächliche Impulsabstand zwischen zwei benachbarten Punkten, die den dimensionslosen Punkten entsprechen, ergibt sich gemäß dem Sampling-Theorem aus den entsprechenden Ausdehnungen des Bildbereichs, $FOV_{y/z}$, beispielsweise gemäß $\Delta k_{y/z} = 1/ (FOV_{y/z}*(1+OS_{x/y}))$.

Die notwendigen Gradientenmomente für die entsprechenden Änderungen der Frequenzraumkoordinaten um $(n_y'-n_y, n_z'-n_z)$ ergibt sich direkt aus der Beziehung $M_{y/z} = (n'_{y/z}-n_{y/z}) *\Delta k_{y/z}/\gamma$. Dabei entspricht $\Delta k_{y/z}$ den entsprechenden dem Sampling-Theorem bestimmten Impulsrauminkrementen und $\gamma$ dem gyromagnetischen Verhältnis.

Der in Fig. 4 bis 6 gezeigte abzutastende k-Raumbereich bezieht sich beispielhaft auf vier simultan angeregte Schichten entlang der $k_z$-Achse und sechzehn mögliche Abtastpunkte innerhalb der Schichtebene entlang der $k_y$-Achse.

Gemäß dem in Fig. 4 dargestellten Abtastschema wird nur eine Zeile des k-Raums entlang der $k_y$-Achse unregelmäßig und unvollständig abgetastet, d.h. $n_z=0$ für alle acht Abtastpunkte P, wobei zur besseren Übersichtlichkeit nur ein Abtastpunkt mit einem Bezugszeichen versehen ist. Die Abtastung erfolgt hier ferner mit variabler Dichte, denn die Dichte der Abtastpunkte P im Zentrum des k-Raum ist höher als am Rand.

In Fig. 5 ist eine vorteilhafte Weiterbildung dargestellt. Gegenüber dem Schema in Abb.4 werden die abzutastenden Punkte gemäß folgender Vorschrift verschoben:

$$n_z = (( n_y + 2 ) \ \mathrm{MOD} \ 4) - 2,$$

wobei MOD die Modulo-Operation darstellt.

Diese Abtastung kann durch Schalten von Schicht-Kodierungs-Blips erreicht werden. Durch unregelmäßige Unterabtastung des $k_y$-$k_z$-Raums können periodischen Unterabtastungsartefakte reduziert werden.

Ein verallgemeinertes k-Raum-Konzept erlaubt aber auch eine vollkommen flexible Verteilung der aufzunehmenden Abtastpunkte, beispielsweise unter dem Gesichtspunkt von CS-Kriterien. So kann das Zentrum des $k_y$-$k_z$-Raums dichter abgetastet werden als die Peripherie, und zu jeder $k_y$-Position können keine, eine oder mehrere Abtastpunkte P abgetastet werden.

Fig. 6 zeigt ein Beispiel einer komplett unregelmäßigen Abtastung. Die aufzunehmenden Abtastpunkte können prinzipiell in beliebiger Reihenfolge aufgenommen werden (wie zum Beispiel für eine zweidimensionale CS-Aufnahme). Zur Generierung eines gewünschten Kontrastes, der durch die Signalamplituden der verschiedenen Gewebetypen zum Zeitpunkt der Aufnahme des k-Raum-Zentrums wesentlich bestimmt ist, können geeignet segmentierte Aufnahmetechniken verwendet werden. Beispielsweise können die aufzunehmenden Abtastpunkte auf mehrere Anregungen einer TSE-Aufnahme verteilt werden.

Für jede simultan angeregte Schichtgruppe können unterschiedliche, unregelmäßige Abtastmuster verwendet werden. Werden beispielsweise mit fünf Anregungen jeweils zwei Schichten simultan angeregt (die Aufnahme bildet also insgesamt zehn Schichten ab), dann können für die Gruppen aus den Schichten {1,6}, {2,7}, {3,8}, {4,9} und {5,10} jeweils individuelle $k_y$-$k_z$-Abtastmuster gewählt werden.

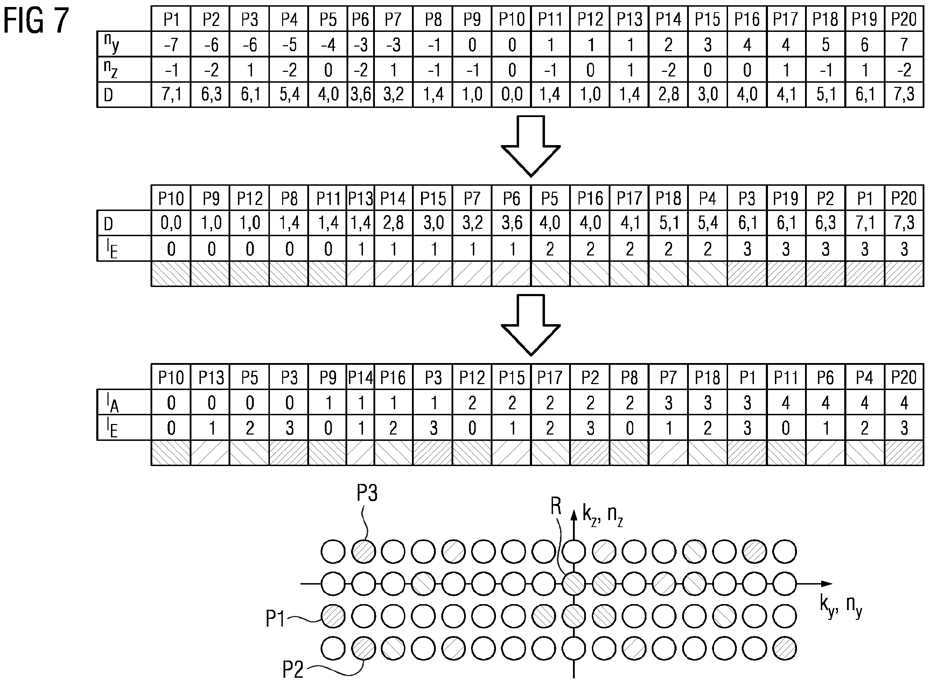

Ausgehend von dem Unterabtastungsschema, das in Fig. 6 gezeigt wird, sollen anhand von Fig. 7 am Beispiel einer TSE-Sequenz Abtastpunkte P in eine zeitliche Abfolge gebracht werden, die von den Abständen der Abtastpunkte P zum Referenzobjekt R abhängig ist. Dabei sollten vier Schichten simultan angeregt werden bei 16 Phasenkodierungsschritten, so dass der k-Raum durch vier $n_z$-Koordinaten und 16 $n_y$-Koordinaten beschrieben wird.

In einer TSE-Bildgebung wird der Bildkontrast (z.B. T2-Gewichtung) davon bestimmt, mit welchem Echoindex $I_E$ das k-Raum-Zentrum ($k_y = 0$) abgetastet wird. Dies beruht darauf, dass mit einer längeren Echozeit TE der Kontrast von einer PD-Wichtung zu einer T2-Wichtung übergeht. Daher kann es von Vorteil sein, das Abtastschema derart zu adaptieren, dass ein gewünschter Kontrast erzielt wird.

Die obere Tabelle der Fig. 7 zeigt die $n_y$- und $n_z$-Koordinaten der Abtastpunkte P1, P2, ..., P20. Als Referenzobjekt R wird das Zentrum des k-Raums festgelegt. Für jeden Abtastpunkt P wird jeweils ein Abstand D von dem Abtastpunkt P1, P2, ..., P20 zum k-Raum-Zentrum R ermittelt. Dies erfolgt hier gemäß der Formel:

$$D=\sqrt{n_y{}^2+n_z{}^2}$$

In der mittleren Tabelle der Fig. 7 werden dann die Abtastpunkte P1, P2, ..., P20 gemäß dem jeweiligen Abstand D in einer Liste sortiert, wobei die Abtastpunkte mit dem geringsten Abstand D am Beginn der Liste stehen. Dies führt durch die folgende Segmentierung schließlich dazu, dass die resultierende TSE-Sequenz PD-gewichtete Magnetresonanzsignale aufnimmt, weil das k-Raum-Zentrum mit möglichst niedrigen Echoindizes abgetastet wird; würde man stattdessen die Abtastpunkte mit dem größten Abstand D an den Beginn der Liste sortieren, erhielte man eine T2-Gewichtung.

Ferner wird eine Segmentierung der Abtastpunkte P1, P2, ..., P20 durch die Segmentierungsindizes Echoindex $I_E$ und Anregungsindex $I_A$ festgelegt. Die Abtastpunkte P mit den kleinsten Abständen D werden gemäß einer Zuordnungsvorschrift dem ersten Echoindex I$_E$ zugeordnet etc. Folglich werden die ersten fünf Abtastpunkten der Liste P10, P9, P12, P8 und P11 dem ersten Echoindex I$_E$=0 zugeordnet, die nächsten fünf Abtastpunkten dem nächsten Echoindex I$_E$=1 etc. (I$_E$=0, 1,...,3). Dadurch werden die Abtastpunkte P1, P2, ..., P20 in vier Segmente segmentiert.

In der unteren Tabelle der Fig. 7 wird jedem Abtastpunkt P1, P2, ..., P20 gemäß der Zuordnungsvorschrift ein Anregungsindex I$_A$(I$_A$=0,1,...,4) eindeutig zugeordnet. Jedem Anregungsindex I$_A$ werden jeweils vier Abtastpunkte mit aufsteigenden Echoindex I$_E$ zugeordnet. Dies entspricht fünf Echozügen bzw. Anregungen (I$_A$=0 bis 4) mit jeweils vier Echos (I$_E$=0 bis 3).

Ferner zeigt Fig. 7 unten ein Unterabtastungsschema aus Fig. 6, bei dem die Abtastpunkte mit gleichem Echoindex I$_E$ eine identische Markierung aufweisen. Zur Erhöhung der Übersichtlichkeit sind lediglich die Abtastpunkte P1, P2 und P3 mit Bezugszeichen versehen. Ferner ist das Referenzobjekt R im Zentrum des dargestellt. In jedem Echozug (umfassend die Echoindizes I$_E$=0 bis 3 wird folglich der k-Raum von innen nach außen abgetastet.

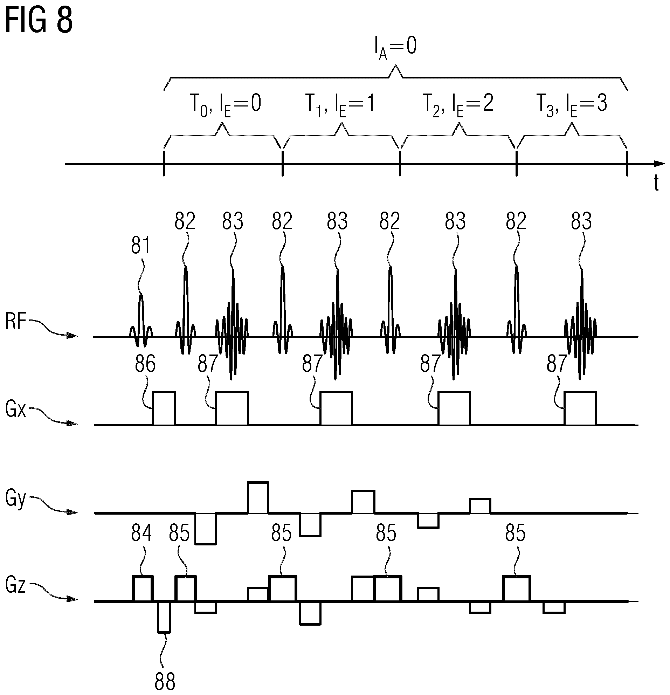

In Fig. 8 ist ein Verlauf einer TSE-Sequenz über die Zeit t für einen vier Echos umfassenden Echozug beispielhaft skizziert. Auf der Achse RF sind ein Anregungspuls 81, mehrere Refokussierungspulse 82 und mehrere ausgelesene Magnetresonanzsignale 83 in Form mehrerer Echos eines Echozuges dargestellt. Die der Anregungspuls 81 und die Refokussierungspulse 82 werden beispielsweise durch Hochfrequenzantenneneinheit 20 erzeugt. Die Magnetresonanzsignale 83 werden beispielsweise mit der Lokalspule 26 aufgenommen.

Die Magnetresonanzmessung lässt sich in Aufnahmezeiträume T$_0$, T$_1$, T$_2$, T$_3$ gliedern, wobei jedem Aufnahmezeitraum T$_0$, T$_1$, T$_2$, T$_3$ ein Segmentierungsindex eindeutig zugeordnet wird: Dem Aufnahmezeitraum T$_0$ wird der Echoindex I$_E$=0 zugeordnet, dem Aufnahmezeitraum T$_1$ wird der Echoindex I$_E$=1 zugeordnet ect. Den dargestellten Aufnahmezeiträumen T$_0$, T$_1$, T$_2$ und T$_3$ kann zusammen beispielsweise der Anregungsindex I$_A$=0 zugeordnet werden. An den in Fig. 8 dargestellten Zeitraum kann sich beispielsweise eine weitere Anregung mit weiteren Aufnahmezeiträumen anschließen, denen der Anregungsindex I$_A$=1 in Verbindung mit Echoindizes I$_E$=0 bis 3 zugeordnet werden.

Bei dem Anregungspuls 81 handelt sich insbesondere um einen 90°-Hochfrequenzpuls. Bei den Refokussierungspulsen 82 handelt sich insbesondere um 180°-Hochfrequenzpulse, auch als 180°-Invertierungspulse bezeichnet. Ein Refokussierungspuls dient dazu, die Kernspins um eine Achse, welche senkrecht zur Ausrichtung des magnetischen Grundfeldes steht, um 180° zu drehen. Vorteilhafterweise sind der Anregungspuls 81 und die Refokussierungspulse 82 ausgebildet, mehrere Schichten simultan anzuregen und/oder zu beeinflussen.

Auf den Achsen Gx, Gy und Gz sind Gradientenmomente dargestellt, insbesondere ein Schichtselektionsgradient 84 zeitgleich zum Anregungspuls 81, ein darauf folgender Rephasierungsgradient 88, Schichtrefokussierungsgradienten 85 zeitgleich zu den Refokussierungspulsen 82, ein Dephasierungsgradient 86 vor dem ersten Refokussierungspuls 82 und Auslesegradienten 87 zeitgleich zu den Magnetresonanzsignalen 83. Die weiteren Gradientenmomente auf der Gy- und Gz-Achse (aus Gründen der Übersichtlichkeit ohne Bezugszeichen) sorgen für eine Ansteuerung der gewünschten Abtastpunkte P im k$_y$-k$_z$-Raum.

Jeder Refokussierungspuls 82 bewirkt einen "Sprung" der k-Raum-Position (Punktspiegelung am Ursprung), der dazu beiträgt, dass Gradientenmomente aufgrund von unerwünschten Störfeldern - beispielsweise aufgrund von lokalen Feldinhomogenitäten - bei der Aufnahme der folgenden Magnetresonanzsignale rephasiert werden. Ferner tragen sie zur wirkungsvollen Überlagerung aller Signalbeiträge stimulierter Echos bei, ebenso wie die identischen Gradientenmomente zwischen jeweils zwei Refokussierungspulsen 82. Letzteres wird erreicht durch paarweise applizierte Phasenkodierungsmomente auf der y- und z-Achse vor und nach dem Auslesen.

Eine "akkumulative" Phasenkodierung wäre grundsätzlich auch bei TSE denkbar, bei der die Phasenkodierungsmomente entlang k$_y$ und k$_z$ zwischen zwei Refokussierungspulsen nicht rephasiert werden. Statt der Paare von Gradienten auf der Gy- und der Gz-Achse wäre dann nur noch jeweils ein Gradient vor dem Auslesen der Magnetresonanzsignale vorhanden.

Beispielsweise können alternierend positive und negative k-Raum-Koordinaten aufgenommen werden.

Es wird abschließend noch einmal darauf hingewiesen, dass es sich bei den vorhergehend detailliert beschriebenen Verfahren sowie bei der dargestellten Systemsteuereinheit und Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

**Patentansprüche**

1. Verfahren zur Magnetresonanzmessung zumindest einer Gruppe simultan angeregter Schichten entlang einer Schichtachse, umfassend:

   - Festlegen eines abzutastenden Frequenzraumbereichs in einem Frequenzraum mittels einer Systemsteuereinheit (22), wobei eine erste Frequenzraumdimension (k$_y$)

einer ersten phasenkodierten Achse zugeordnet wird,

wobei eine zweite Frequenzraumdimension ($k_z$) einer zweiten phasenkodierten Achse zugeordnet wird und die zweite phasenkodierte Achse der Schichtachse entspricht;

- Festlegen eines mehrere Abtastpunkte (P) umfassenden Unterabtastungsschemas für jede Gruppe der simultan angeregten Schichten mittels der Systemsteuereinheit (22),

wobei entlang der ersten Frequenzraumdimension ($k_y$) und/oder zweiten Frequenzraumdimension ($k_z$) eine unregelmäßige, unvollständige Abtastung des Frequenzraumbereichs vorgesehen wird;

- Durchführen der Magnetresonanzmessung der zumindest einen Gruppe der simultan angeregten Schichten entlang der Schichtachse gemäß dem jeweiligen Unterabtastungsschema zur Akquisition von Magnetresonanzsignalen.

2.  Verfahren nach Anspruch 1,
    wobei entlang der ersten Frequenzraumdimension ($k_y$) und zweiten Frequenzraumdimension ($k_z$) eine unregelmäßige, unvollständige Abtastung des Frequenzraumbereichs vorgesehen wird.

3.  Verfahren nach einem der vorangehenden Ansprüche,
    wobei die Dichte der Abtastpunkte (P) im abzutastenden Frequenzraumbereich variiert, insbesondere in Abhängigkeit von ihrem Abstand (D) zu zum Zentrum des abzutastenden Frequenzraumbereichs.

4.  Verfahren nach einem der vorangehenden Ansprüche, wobei

    - im Frequenzraum ein Referenzobjekt (R), insbesondere zumindest eine Referenzlinie und/oder zumindest ein Referenzpunkt, festgelegt wird,
    wobei für jeden Abtastpunkt (P) jeweils ein Abstand (D) von dem Abtastpunkt (P) zum Referenzobjekt (R) ermittelt wird,
    - die Abtastpunkte (P) in einer zeitlichen Abfolge abgetastet werden, die von den Abständen der Abtastpunkte (P) zum Referenzobjekt (R) abhängig ist.

5.  Verfahren nach Anspruch 4,
    wobei sich das Referenzobjekt (R) im Zentrum oder an einem Rand des abzutastenden Frequenzraumbereichs befindet.

6.  Verfahren nach Anspruch 4 oder 5,
    wobei der Abstand (D) ein kartesischer Abstand zum Referenzobjekt (R) und/oder ein Abstand zum Referenzobjekt (R) mit unterschiedlicher Gewichtung hinsichtlich der ersten Frequenzraumdimension ($k_y$) und der zweiten Frequenzraumdimension ($k_z$) ist.

7.  Verfahren nach einem der Ansprüche 4 bis 6,
    wobei jedem Abtastpunkt (P) zumindest ein Segmentierungsindex ($I_A$, $I_E$) in Abhängigkeit von dem Abstand (D) der Abtastpunkte (P) zum Referenzobjekt (R) zugeordnet wird,
    wobei zur Durchführung der Magnetresonanzmessung Magnetresonanzsignale während zugehöriger Aufnahmezeiträume (T0, T1, T2, T3) aufgenommen werden und jedem Aufnahmezeitraum (T0, T1, T2, T3) zumindest ein Segmentierungsindex ($I_E$) eindeutig zugeordnet wird.

8.  Verfahren nach Anspruch 7,
    wobei der zumindest eine Segmentierungsindex einen Anregungsindex ($I_A$) einer Abfolge von Anregungspulsen und/oder einen Echoindex ($I_E$) eines Echos eines Echozuges in Folge eines Anregungspulses umfasst.

9.  Verfahren nach einem der vorangehenden Ansprüche, wobei

    - die zumindest eine Gruppe simultan angeregter Schichten mehrere Gruppen simultan angeregter Schichten sind,
    - die Unterabtastungsschemata der mehreren Gruppen der simultan angeregten Schichten identisch sind oder sich voneinander unterscheiden.

10. Verfahren nach einem der vorangehenden Ansprüche,
    wobei die Magnetresonanzsignale mittels einer iterativen Rekonstruktionstechnik, insbesondere mittels einer Compressed-Sensing-Technik, rekonstruiert werden.

11. Verfahren nach Anspruch 10, wobei
    die iterative Rekonstruktionstechnik eine Regularisierung der Magnetresonanzsignale entlang der zweiten Frequenzraumdimension ($k_z$) umfasst.

12. Verfahren nach einem der vorangehenden Ansprüche, wobei

    - die Akquisition der Magnetresonanzsignale mittels mehrerer Spulenelemente erfolgt,
    - Empfangsprofile der Spulenelemente erfasst werden,
    - die Magnetresonanzsignale unter Berücksichtigung der Empfangsprofile der Spulenelemente rekonstruiert werden.

13. Verfahren nach einem der vorangehenden Ansprüche,

wobei die Magnetresonanzmessung gemäß einer der folgenden Sequenztypen durchgeführt wird:

   - Turbo Spin-Echo (TSE)
   - Single-Shot Echo-Planar-Imaging (ss-EPI),
   - Multi-Shot Echo-Planar-Imaging (ms-EPI),
   - Gradient Recalled Echo (GRE),
   - Gradient and Spin Echo (GRASE),
   - Fast Imaging with Steady State Precession (FISP).

**14.** Magnetresonanzvorrichtung (10), welche ausgebildet ist, ein Verfahren nach einem der Ansprüche 1 bis 13 auszuführen.

**15.** Computerprogrammprodukt, welches ein Programm umfasst und direkt in einen Speicher einer programmierbaren Systemsteuereinheit (22) einer Magnetresonanzvorrichtung (10) ladbar ist, mit Programmmitteln, um ein Verfahren nach einem der Ansprüche 1 bis 13 auszuführen, wenn das Programm in der Systemsteuereinheit (22) der Magnetresonanzvorrichtung (10) ausgeführt wird.

FIG 1

## FIG 2

## FIG 3
(Stand der Technik)

FIG 4

FIG 5

FIG 6

# FIG 7

| | P1 | P2 | P3 | P4 | P5 | P6 | P7 | P8 | P9 | P10 | P11 | P12 | P13 | P14 | P15 | P16 | P17 | P18 | P19 | P20 |
|---|---|---|---|---|---|---|---|---|---|---|---|---|---|---|---|---|---|---|---|---|
| $n_y$ | -7 | -6 | -6 | -5 | -4 | -3 | -3 | -1 | 0 | 0 | 1 | 1 | 1 | 2 | 3 | 4 | 4 | 5 | 6 | 7 |
| $n_z$ | -1 | -2 | 1 | -2 | 0 | -2 | 1 | -1 | -1 | 0 | -1 | 0 | 1 | -2 | 0 | 0 | 1 | -1 | 1 | -2 |
| D | 7,1 | 6,3 | 6,1 | 5,4 | 4,0 | 3,6 | 3,2 | 1,4 | 1,0 | 0,0 | 1,4 | 1,0 | 1,4 | 2,8 | 3,0 | 4,0 | 4,1 | 5,1 | 6,1 | 7,3 |

| | P10 | P9 | P12 | P8 | P11 | P13 | P14 | P15 | P7 | P6 | P5 | P16 | P17 | P18 | P4 | P3 | P19 | P2 | P1 | P20 |
|---|---|---|---|---|---|---|---|---|---|---|---|---|---|---|---|---|---|---|---|---|
| D | 0,0 | 1,0 | 1,0 | 1,4 | 1,4 | 1,4 | 2,8 | 3,0 | 3,2 | 3,6 | 4,0 | 4,0 | 4,1 | 5,1 | 5,4 | 6,1 | 6,1 | 6,3 | 7,1 | 7,3 |
| $I_E$ | 0 | 0 | 0 | 0 | 0 | 1 | 1 | 1 | 1 | 1 | 2 | 2 | 2 | 2 | 2 | 3 | 3 | 3 | 3 | 3 |

| | P10 | P13 | P5 | P3 | P9 | P14 | P16 | P3 | P12 | P15 | P17 | P2 | P8 | P7 | P18 | P1 | P11 | P6 | P4 | P20 |
|---|---|---|---|---|---|---|---|---|---|---|---|---|---|---|---|---|---|---|---|---|
| $I_A$ | 0 | 0 | 0 | 0 | 1 | 1 | 1 | 1 | 2 | 2 | 2 | 2 | 2 | 3 | 3 | 3 | 4 | 4 | 4 | 4 |
| $I_E$ | 0 | 1 | 2 | 3 | 0 | 1 | 2 | 3 | 0 | 1 | 2 | 3 | 0 | 1 | 2 | 3 | 0 | 1 | 2 | 3 |

EP 3 839 548 A1

## FIG 8

Europäisches
Patentamt

European
Patent Office

Office européen
des brevets

**EUROPÄISCHER RECHERCHENBERICHT**

Nummer der Anmeldung

EP 19 21 7905

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>Y | EP 3 561 535 A1 (SIEMENS HEALTHCARE GMBH [DE]) 30. Oktober 2019 (2019-10-30)<br>* Abbildungen 1,2,3,4,5 *<br>* Absatz [0027] - Absatz [0033] *<br>* Absatz [0039] - Absatz [0041] *<br>* Absatz [0045] - Absatz [0046] *<br>* Absatz [0064] *<br>* Absatz [0071] - Absatz [0113] *<br>----- | 1,3-15<br><br>4-8 | INV.<br>G01R33/561<br>G01R33/48<br>G01R33/483 |
| X<br><br><br><br><br><br><br><br><br><br>Y | CHIEW MARK ET AL: "Improved statistical efficiency of simultaneous multi-slice fMRI by reconstruction with spatially adaptive temporal smoothing", NEUROIMAGE, ELSEVIER, AMSTERDAM, NL, Bd. 203, 5. September 2019 (2019-09-05), XP085894936, ISSN: 1053-8119, DOI: 10.1016/J.NEUROIMAGE.2019.116165 [gefunden am 2019-09-05]<br>* Abbildung 1 *<br>* Abschnitt "1. Introduction" *<br>* Abschnitt "2. Theory" *<br>* Abschnitt "3. Methods" *<br>----- | 1,2,4-15<br><br><br><br><br><br><br><br><br><br>4-8 | |
| X<br><br>Y | US 2015/301145 A1 (KERR ADAM B [US] ET AL) 22. Oktober 2015 (2015-10-22)<br>* Abbildungen 2,3,11,12 *<br>* Absatz [0028] - Absatz [0043] *<br>* Absatz [0053] *<br>* Absatz [0069] - Absatz [0070] *<br>----- | 1,3-15<br><br>4-8 | |
| X<br><br><br>Y | EP 3 100 067 A1 (MASSACHUSETTS GEN HOSPITAL [US]) 7. Dezember 2016 (2016-12-07)<br>* Abbildung 3 *<br>* Absatz [0015] - Absatz [0038] *<br>----- | 1,3-15<br><br><br>4-8 | |
| | -/-- | | |

RECHERCHIERTE SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 9. Juni 2020 | Durst, Markus |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument

............................................................................
& : Mitglied der gleichen Patentfamilie, übereinstimmendes
  Dokument

EPO FORM 1503 03.82 (P04C03)

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | BILGIC BERKIN ET AL: "Simultaneous Time Interleaved MultiSlice (STIMS) for Rapid Susceptibility Weighted acquisition", NEUROIMAGE, ELSEVIER, AMSTERDAM, NL, Bd. 155, 20. April 2017 (2017-04-20), Seiten 577-586, XP085125318, ISSN: 1053-8119, DOI: 10.1016/J.NEUROIMAGE.2017.04.036 | 1-15 | |
| Y | * Abbildung 1 * <br> * erster Paragraph der linken Spalte auf Seite 578 * <br> * vierter Paragraph der linken Spalte bis zweiter Paragraph der rechten Spalte auf Seite 578 * <br> * Abschnitt "Pulse sequence and RF excitation design" auf Seite 579 * <br> * Abschnitt "STIMS CS-Wave acquisition at 3T using 2-fold echo-shift: (Rstims=2, Rcs-wave =15)" * <br> * Abschnitt "STIMS CS-Wave acquisition at 3T using 3-fold echo-shift (Rstims=3, Rcs-wave=15)" * | 4-8 | |
| | ----- | | RECHERCHIERTE SACHGEBIETE (IPC) |
| Y | REED F BUSSE ET AL: "Effects of refocusing flip angle modulation and view ordering in 3D fast spin echo", MAGNETIC RESONANCE IN MEDICINE, JOHN WILEY & SONS, INC, US, Bd. 60, Nr. 3, 1. September 2008 (2008-09-01), Seiten 640-649, XP002626697, ISSN: 0740-3194, DOI: 10.1002/MRM.21680 [gefunden am 2008-08-25] * Abbildung 3 * <br> * Abschnitt "View-Ordering Technique" * | 4-8 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| München | 9. Juni 2020 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 19 21 7905

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | AKIO YOSHIMOTO ET AL.: "Rapid knee MRI using TSE sequences accelerated with a combination of simultaneous multislice, multicoil compressed sensing and elongated echo trains", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 1150, 7. April 2017 (2017-04-07), XP040688718, * das ganze Dokument * ----- | 1-15 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 9. Juni 2020 | Durst, Markus |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

Seite 3 von 3

## ANHANG ZUM EUROPÄISCHEN RECHERCHENBERICHT
## ÜBER DIE EUROPÄISCHE PATENTANMELDUNG NR.

EP 19 21 7905

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-06-2020

| Im Recherchenbericht angeführtes Patentdokument | Datum der Veröffentlichung | Mitglied(er) der Patentfamilie | Datum der Veröffentlichung |
|---|---|---|---|
| EP 3561535 A1 | 30-10-2019 | CN 110412493 A<br>EP 3561535 A1<br>US 2019331749 A1 | 05-11-2019<br>30-10-2019<br>31-10-2019 |
| US 2015301145 A1 | 22-10-2015 | KEINE | |
| EP 3100067 A1 | 07-12-2016 | EP 3100067 A1<br>US 2016341807 A1<br>WO 2015116894 A1 | 07-12-2016<br>24-11-2016<br>06-08-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **PUBLIKATION GRISWOLD et al.** Generalized autocalibrating partially parallel acquisitions (GRAPPA). *Magn Reson Med.,* Juni 2002, vol. 47 (6), 1202-10
- **PRUESSMANN et al.** SENSE: sensitivity encoding for fast MRI. *Magn Reson Med.,* November 1999, vol. 42 (5), 952-62

- **LARKMAN et al.** Use of multicoil arrays for separation of signal from multiple slices simultaneously excited. *J Magn Reson Imaging,* Februar 2001, vol. 13 (2), 313-7
- **BREUER et al.** Controlled aliasing in volumetric parallel imaging (2D CAIPIRINHA). *Magn Reson Med.,* Marz 2006, vol. 55 (3), 549-56
- **LUSTIG et al.** Compressed sensing MRI. *IEEE Signal Process Mag,* 2008, vol. 25 (2), 72-82